# EUROPEAN PATENT APPLICATION

(11) **EP 1 908 981 A1**
(43) Date of publication of application: **09.04.2008**
(21) Application number: 07117493.2
(22) Date of filing: 28.09.2007
(51) Int. Cl.: F16D 65/78, H01L 35/32

(54) **Braking device provided with peltier cell bases cooling means**

(30) Priority: 29.09.2006 IT MI20061868
(71) Applicant: Motorquality S.p.A, 20099 Sesto San Giovanni (MI) (IT)
(72) Inventor: Mercandelli, Flavio, 20099 Sesto San Giovanni (MI) (IT); Zanini, Bruno, 20099 Sesto San Giovanni (MI) (IT)
(74) Representative: Fisauli, Beatrice A. M.

(57) **Abstract**

This invention concerns a braking device equipped with active cooling devices, in particular constituted by Peltier cells.

The braking device (1), which includes devices designed to create a thrust that pushes friction elements, such as pads or shoes, against a rotating element, respectively a disk or drum, is characterized by the provision of active cooling devices applied to said brake system (1). These active cooling devices include one or more Peltier cells (2, 10), which are mounted so that one sheet (2a, 10a) is in contact with a hot part of the brake system (1), and are powered by voltage that cools the first sheet (2a, 10a), transferring at least part of the heat produced by this brake system (1) to a second sheet (2b, 10b) of these Peltier cells (2, 10), with the second sheet (2b, 10b) dispersing heat to the outside.

## Description

This invention concerns a braking device equipped with active cooling devices, in particular consisting of Peltier cells.

Braking device are, by nature, sources of large quantities of heat, in that they transform the kinetic energy of the masses that must be braked into thermal energy.

There are various kinds of brakes for various purposes, for example brakes for various kinds of machines, such as cable systems, or for transport vehicles, both automobiles and industrial vehicles or trains. In all these cases, the brake includes a rotating part that is,solidly connected to the mass to be braked, or mounted on it, which is subjected to the action of shoes or pads that use friction to act on this rotating element, as they are pressed against it using special devices that are primarily mechanical or hydraulic in nature.

In the vast majority of cases, braking produces large quantities of heat, which causes a considerable increase in the temperature of the entire braking device. In extreme cases, as in airplane and race car brakes, temperatures are so high that they exceed 1000°C, which requires the use of special materials such as carbon-carbon composites, while still requiring a great deal of ventilation to disperse the heat produced after transforming kinetic energy into thermal energy.

For vehicles, it is relatively easy to provide ventilation, as it is the vehicle's movement itself that creates the necessary flow of air.

Nevertheless, in certain situations, the flow itself may not be enough to contain temperatures even for just a few moments, with excessive temperatures causing the phenomenon of fading.

A situation of this kind occurs when the braking device is repeatedly used, such as, for example, when a vehicle is moving at high speed on a road with many curves, especially going downhill. In this case, the braking action is energetic and frequently repeated, with no chance to achieve complete cooling between one braking action and the next. What thus happens is that with each braking action, the temperature increases more or less significantly, until the heat, which in the meantime has spread to the hydraulic system, causes the vaporization of small quantities of oil, consequently making it impossible to achieve the pressure necessary to exert effective braking action.

Under these conditions, the braking device fails, with clearly grave dangers to the safety of the vehicle's occupants.

It should also be noted that in this case it is not enough to wait for the temperature of the brake calipers or other braking device to drop back below the maximum permitted temperature, which is a relatively easy process if the vehicle continues to move, even at a lower speed, due to the ventilation generated. In fact, the overheated oil flows through the hydraulic circuit, the portion of which near the wheels contains components made of elastomeric materials, as the part needs to be flexible. These materials are by nature heat insulating, thus the oil remains at a temperature high enough to form steam bubbles for a much longer time than what is required to bring the calipers back down to the proper temperature.

Even without reaching the threshold described, in ordinary use it is still advisable to keep operating temperatures down. According to the known technology, this is accomplished through adequate ventilation and/or by increasing the dimensions of the braking parts, in order to minimize the increase in temperature by adequately increasing the system's thermal mass.

With regard to ventilation, it should be noted that it is not easy to provide special air conveyors for mass-produced vehicles, while in terms of braking device design, it should be noted that for both economic and operating reasons, efforts are made to keep the brake parts as small as possible. For use on automobiles, weight is a determining factor in evaluating the quality of a braking device, as brake elements such as disks and calipers are almost always located on wheels and thus constitute non-suspended masses that must be as light as possible.

This invention resolves the problems of overheating the braking device through the use of active cooling devices, i.e. which are not limited to simple ventilation, applied in one or two areas of this braking device, in conformity with claim 1.

These active cooling devices include Peltier cells, which, as is known, make use of the thermoelectric effect to conduct heat between two sheets, appropriately connected to each other and subjected to a difference in potential. In practice, one of the two sheets cools while the other one heats up. By placing the cold sheet in contact with the part that we want to cool, we achieve the effect of removing heat from it and transferring it to the hot sheet of the Peltier cell. The hot sheet then will reach a temperature higher than the one the brake part would reach in the absence of the cell, due to the transfer of heat as a result of the thermoelectric effect. As a result, the heat exchange with the outside, preferably with an adequate flow of air and the use of elements that increase the heat exchange, becomes more efficient and thus reduces the temperature of the braking element.

For purposes of reducing the temperature of the oil in the pipes, it is sufficient to equip the hot area of the pipes with one or more appropriately shaped Peltier cells, in order to effectively cool the oil.

The Peltier cells can be very thin, so their application to a braking mechanism does not substantially alter its dimensions, while the fact that the hot sheet of the cells themselves reaches temperatures higher than what would be reached by the braking element in the absence of the Peltier cell makes the heat exchange significantly more efficient, with ventilation being equal.

Finally, the invention automatically controls the function of the Peltier cells, with this control taking place, in conformity with known technology, through the use of a temperature sensor positioned on the braking device to be cooled.

The effect achieved through the invention is thus to contain the operating temperature of the braking device, thereby improving its performance.

This fact has two important consequences, as it makes it possible to reduce the size of the braking elements, with performance being equal, with consequent economic advantages and, in the case of automobiles, reducing non-suspended masses.

The invention will now be described using an indicative example only, based on a preferred form of implementation and referring to the attached figures, where:
- figure 1 shows the position of circular-shaped Peltier cells located at the imprint of the pistons of a caliper for a disk brake
- figures 2, 3 and 4 show other possible areas of application for Peltier cells on the caliper body of a caliper for a disk brake
- figures 5, 6 and 7 show the installation of protective and heat exchange elements applied on the outside of the Peltier cells
- figure 8 shows the installation of protection and heat exchange elements, in an appropriately shaped structure, aimed at optimizing the radiant surface, applied to the outside of the Peltier cells
- figure 9 shows the installation of a Peltier cell inside a brake caliper
- figures 10 (a, b) show a cylindrical-shaped Peltier cell, utilized to directly cool the oil of the hydraulic circuit that drives the braking device.

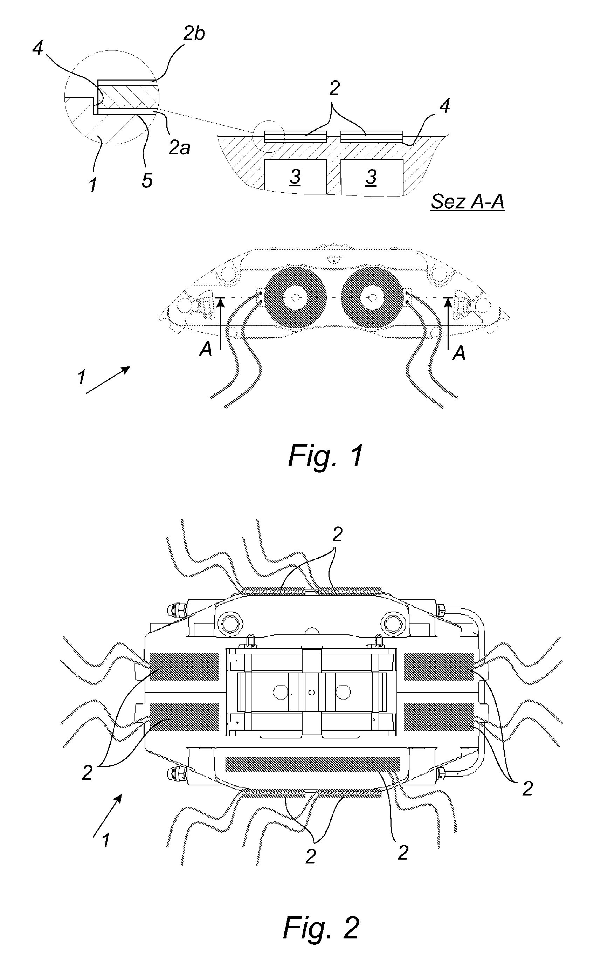

In fig. 1, (1) indicates a caliper for a disk brake, to which two circular Peltier cells have been affixed (2), at the cylinders (3) where the pistons that drive the pads run. The cross-section shows how the Peltier cells (2) are advantageously housed in special circular recesses (4) positioned at the cylinders (3).

The Peltier cells (2) can be fixed mechanically in the position indicated, or glued on with high heat conducting adhesives.

In the enlarged detail in fig. 1, we see how the Peltier cell (2), which includes a first inner sheet (2a) and a second outer sheet (2b), is inserted into this recess, or housing (4), with the inner sheet (2a) in contact with the body of the caliper (1). Obviously, the cell (2) will be powered so that the inner sheet (2a) is being cooled through a thermoelectric effect.

According to the preferred embodiment, the inner sheet (2a) is glued on with a layer of adhesive (5) that must be able to withstand the operating temperature of the brake caliper, which may be as high as 200°C, and should preferably be the high heat conduction type. In the alternative, the cell (2) can be affixed mechanically, according to known technology.

Fig. 2 shows other possible applications for the Peltier cells (2) on the caliper body, for example on the sides of the caliper (1) and where the disk passes through, in addition to those already described, positioned at the cylinders (3).

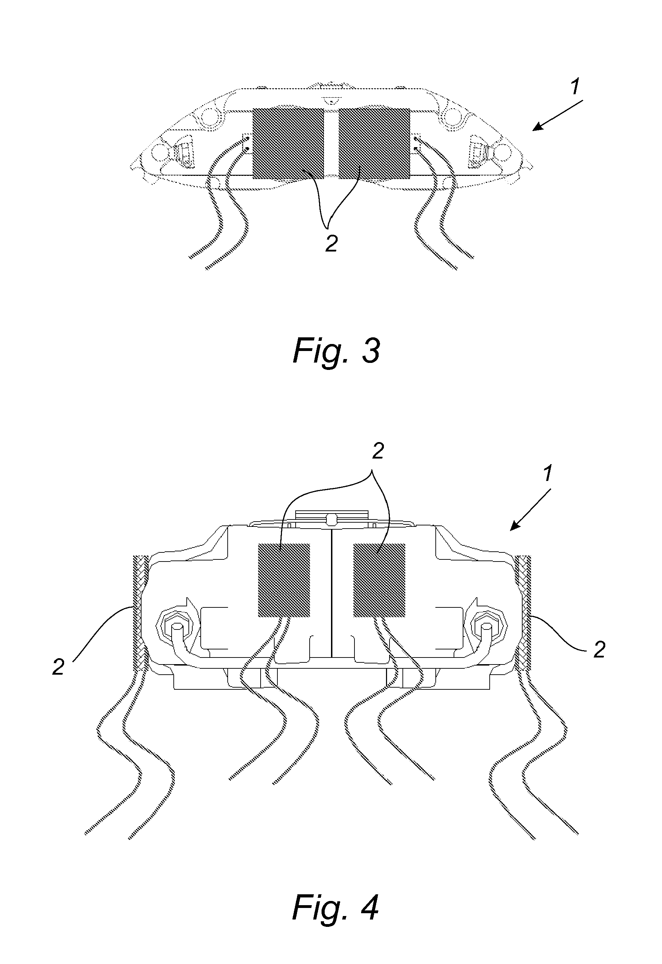

Fig. 3 shows an installation similar to that in fig. 1, that is at the imprint of the pistons, but with square-shaped cells (2).

Fig. 4 shows an installation of Peltier cells (2) in the lower part and on the sides of the caliper (1).

In figures 1 ÷ 4, the cells are applied to the outside surface of the brake caliper with no additional protection. Nevertheless, devices aimed at providing mechanical protection against shocks and abrasions may be used to advantage, preferably made of materials with high heat conduction properties, to permit the dispersal of heat.

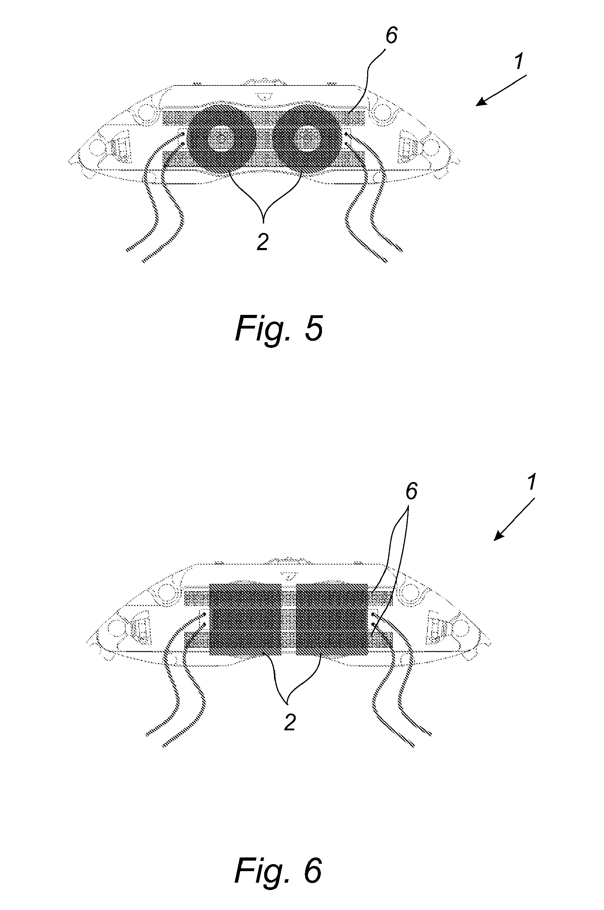

In fig. 5, these means of protection and heat dispersal include small sheets or plates (6), positioned at the cylinders (3) and applied to the outside of Peltier cells (2).

Fig. 6 shows the same sheets (6) applied to square-shaped Peltier cells (2), also positioned at the cylinders (3).

These sheets (6) are preferably made of copper or aluminum alloys, by virtue of the high heat conduction properties of these alloys.

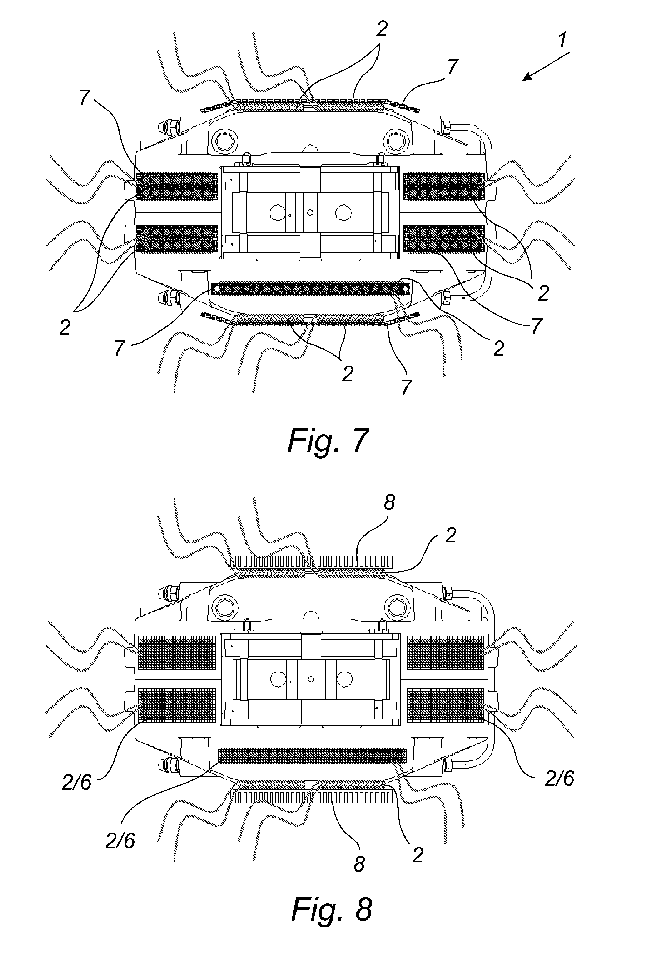

Fig. 7 shows an installation of Peltier cells (2), like that demonstrated in fig. 2, but with the cells protected by small perforated plates (7), with the perforations acting to increase the radiant surface.

These devices, which can provide mechanical protection against shocks and abrasions, can be shaped appropriately in order to increase the radiant surface exposed to the outside environment.

Fig. 8 shows a new possible installation of Peltier cells (2) protected by protective and heat exchange devices (6) and (8), made of materials with high heat conduction properties. In particular, the elements (8) are made of finned bars in order to increase the radiant surface.

According to a preferred embodiment, protection and heat exchange devices (not shown) can be connected to a circuit in which a heat conveying liquid flows, transporting the heat from the braking device to a radiator that leads to the outside.

In figures 1 to 8, the Peltier cells are applied to the outer surface of the brake caliper (1), if necessary creating appropriately-shaped housing to contain the cells and, preferably subjecting the application zone to appropriate machine tooling, in order to match the surface of the caliper with the cooling surface of the Peltier-effect element, that is guaranteed by the planarity of the surfaces in contact, in order to maximize the heat exchange between these two surfaces in contact.

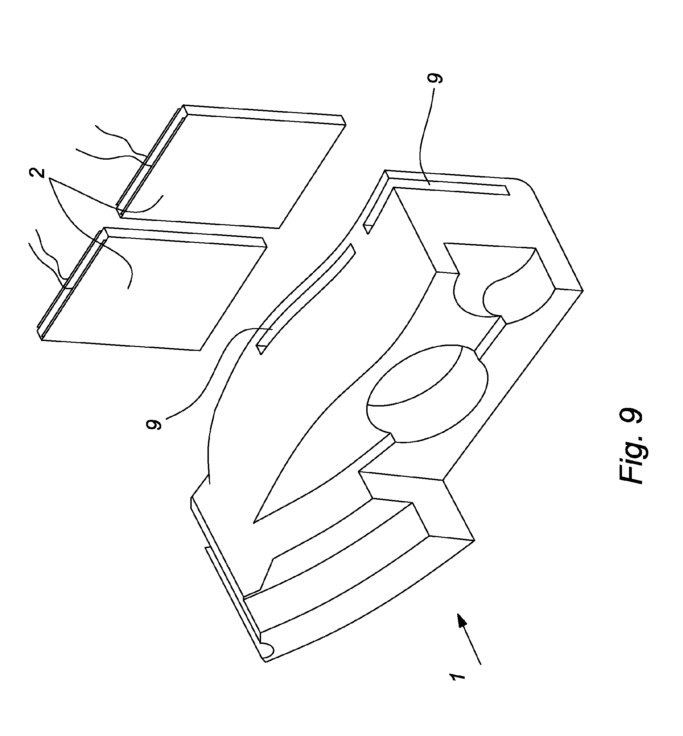

In the alternative, as shown in figure 9, one or more Peltier cells (2) can be positioned immediately below the outside surface of the brake caliper, creating appropriate housing (9) in the caliper body, for example by machine tooling the application area in order to create a negative imprint with a shape the same as the shape of the Peltier cell (2).

In this case, the mechanical protection is created by the outer surface of the caliper itself, which also acts as a material for the transmission and dissipation of heat.

The transmission of heat between the brake caliper and the Peltier cells (2) is ensured by the fact that the cells (2) are locked into the housings (9) with an adhesive gel with high thermal conduction properties.

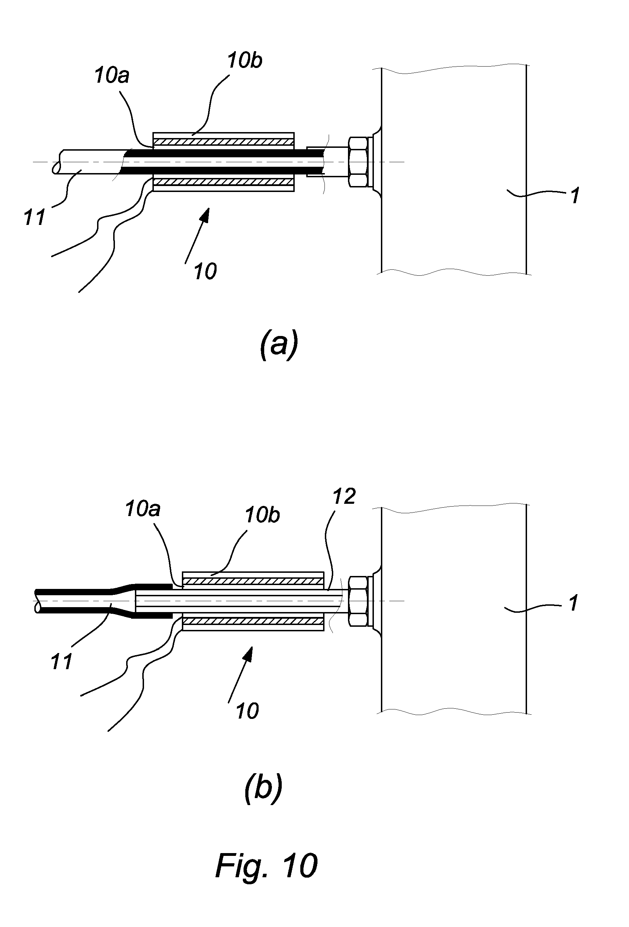

By adequately shaping a Peltier cell, it is also possible to cool the pipes of the hydraulic system. For example, by creating a Peltier cell (10) with two concentric cylindrical sheets, one internal (10a) and one external (10b), a tubular element is produced that can be slipped onto the tube (11) that carries oil to the brake caliper (1), as shown in fig. 10a, or be made part of the tube itself (11).

Fig. 10b shows a possible configuration of the cell (10) that is mounted on a metal pipe (12), which acts as a connection between the brake caliper (1) and the tube (11).

By powering the cell (10) in order to cool the inner sheet (10a), it will be possible to adequately and directly cool the oil, preventing the phenomenon of fading or at least restoring optimal operating conditions much more quickly if the phenomenon does occur.

Obviously, the Peltier cells (10) can also be covered with protective and heat exchange devices (6), (7) and (8), or connected to a cooling circuit that contains a heat conducting liquid.

The decision to use Peltier cells must be made based on the thermal power required for proper cooling of the mechanical parts to which they are applied and the temperature difference that needs to be maintained between the two surfaces of the cell.

According to the preferred embodiment of the invention, the Peltier cells can be equipped with a temperature control system in order to maintain the temperature of the braking device (1) within set limits. The automatic temperature control loop is created by positioning a temperature transducer (thermistor) in the area where one wants to control the temperature. The thermistor, appropriately connected to the power system, permits the automatic regulation of voltage or power supply, which directly correlates to the temperature difference between the two sides of the Peltier cell.

As the method for controlling temperature is itself well-known, it will not be described further.

From the preceding description, it is clear how the use of small elements like Peltier cells make it possible to improve the cooling of a braking device. Better cooling will make it possible to improve the performance of the braking device or, once the maximum operating temperature for said braking device is established, the use of Peltier cells as described in the invention, makes it possible to create a smaller braking device, with consequent advantages in terms of both cost reduction and the reduction of non-suspended masses.

Although the invention has been described for the application of Peltier cells to a brake caliper, the concepts described can also be used to apply the cells to drum brakes, in particular to the cylinders powering the shoes.

Shown are some examples of braking elements provided with Peltier cells, as described by the invention. An expert in the sector would not have any difficulty in devising numerous variations, all included within the sphere of protections of the following claims.

## Claims

1. Braking device (1), including means designed to exert a thrust that pushes friction parts such as pads or shoes, against a rotating part, respectively a disk or drum, **characterized in that** active cooling means are applied to said braking device (1), with said active cooling means including one or more Peltier cells (2, 10), which are mounted in a way so that a firs sheet (2a, 10a) is in contact with a hot part of this braking device (1), and are powered with voltage that cools said first sheet (2a, 10a), transferring at least part of the heat produced by said braking device (1) to a second sheet (2b, 10b) of said Peltier cells (2, 10), with this second sheet (2b, 10b) dispersing heat to the outside atmosphere.

2. Braking device (1), according to claim 1, **characterized in that** it provides for means designed to dissipate the heat produced by said braking device (1) and transferred to said second sheet (2b, 10b) of said Peltier cells (2, 10).

3. Braking device (1), according to claim 2, **characterized in that** said means, designed to dissipate the heat produced by said braking device (1) and transferred to said second sheet (2b, 10b) of said Peltier cells (2, 10), include metallic plates (6, 7) in contact with said second sheets (2b) of said Peltier cells (2, 10).

4. Braking device (1), according to claim 3, **characterized in that** said metallic plates (7), applied to the outside of said Peltier cells (2, 10), are perforated in order to increase the heat exchange surface.

5. Braking device (1), according to claim 2, **characterized in that** said means designed to dissipate the heat produced by said braking device (1) and transferred to said second sheet (2b, 5b) of said Peltier cells (2, 10) include finned bars (8) in contact with said second sheets (2b) of said Peltier cells (2, 10).

6. Braking device (1), according to claims 2 to 5, **characterized in that** said means, designed to dissipate the heat produced by said braking device (1) and transferred to said second sheet (2b, 10b) of said Peltier cells (2, 10), are also designed to protect said Peltier cells (2, 10) from abrasions and shocks.

7. Braking device (1), according to claim 2, **characterized in that** said means designed to dissipate the heat produced by said braking device (1) transferred to said second sheet (2b, 10b) of said Peltier cells (2, 10), include a hydraulic circuit containing heat conducting liquid designed to transport the heat from the braking device to a radiator communicating with the outside, with said hydraulic circuit exchanging heat with said second sheets (2b, 10b) of said Peltier cells (2, 10).

8. Braking device (1), according to claim 1, **characterized in that** said Peltier cells (2) are mounted inside housings (4, 9) carried out on said braking device (1).

9. Braking device (1), according to claim 8, **characterized in that** these housings (4) are open.

10. Braking device (1), according to claim 8, **characterized in that** these housings (9) are located inside the body of this braking device (1).

11. Braking device (1), according to claims 8 to 10, **characterized in that** means are provided, designed to aid heat exchange between this braking device (1) and the Peltier cells (2).

12. Braking device (1), according to claim 13, **characterized in that** said means designed to aid the exchange of heat between said braking device (1) and said Peltier cells (2) include high heat conductive adhesive gel.

13. Braking device (1), according to claim 1, **characterized in that** said Peltier cell (10) is slipped onto said tube (11).

14. Braking device (1), according to claim 1, **characterized in that** said Peltier cell (10) is designed to constitute a piece of said tube (11).

15. Braking device (1), according to any of claims 1 to 14, in that means are provided designed to automatically control the operation of said Peltier cells (2, 10), based on the temperature of the braking device (1).

16. Braking device (1), according to claim 15, **characterized in that** said means, designed to automatically control the operation of said Peltier cells (2, 10), depending on the temperature of said braking device (1), include a temperature transducer located in the area where the temperature control is desired, connected to a power system designed to automatically regulate the voltage and power supply for said Peltier cells (2,10).
